# EUROPEAN PATENT SPECIFICATION

(11) **EP 3 813 030 B1**
(45) Date of publication and mention of the grant of the patent: **07.05.2025**
(21) Application number: 20781428.6
(22) Date of filing: 11.08.2020
(51) Int. Cl.: G07C 5/08, H05K 5/00

(54) **VEHICLE-MOUNTED BLACK BOX PROTECTOR**
FAHRZEUGMONTIERTER FAHRDATENSCHREIBERSCHUTZ
DISPOSITIF DE PROTECTION DE BOÎTE NOIRE MONTÉ SUR VÉHICULE

(30) Priority: 19.08.2019 CN 201921350169 U
(43) Date of publication of application: 28.04.2021
(73) Proprietor: CRSC RESEARCH & DESIGN INSTITUTE GROUP CO., LTD., Fengtai District Beijing 100070 (CN)
(72) Inventor: QI, Han, Beijing 100070 (CN); SUN, Chao, Beijing 100070 (CN); YE, Feng, Beijing 100070 (CN); TAN, Xiao, Beijing 100070 (CN); LUO, Xu, Beijing 100070 (CN)
(74) Representative: Huang, Liwei
(86) International application number: PCT/CN2020/108330
(87) International publication number: WO 2021/031918

(56) References cited:
- WO-A1-2018/093773
- WO-A1-2019/084485
- WO-A1-91/04921
- CN-A- 107 481 352
- CN-U- 204 965 537
- CN-U- 204 965 537
- CN-U- 206 115 515
- CN-U- 207 752 533
- CN-U- 207 753 974
- CN-U- 207 817 803
- CN-U- 208 530 462
- CN-U- 210 377 575
- RU-C2- 2 651 428
- US-A- 5 123 538
- US-A1- 2014 022 722

## Description

### TECHNICAL FIELD

The present disclosure relates to a technical field of vehicle-mounted devices of railway communicating signal devices, and particularly to a protector for a vehicle-mounted black box.

### BACKGROUND

A vehicle-mounted black box, also referred to as a vehicle-mounted work information recorder, is designed to record driving speed, vehicle geographic location, and brake system status, etc., so that vehicle operating information may be recorded, which helps to obtain on-site fault information, facilitate fault reproduction, reduce labor costs, provide effective testing means for daily maintenance of a train and timely finding causes of sudden traffic accidents to reduce vehicle failures, provide basis for product design and failure analysis, and has important practical effects and significance for in-depth study of perfect design, failure analysis, cost reduction and traffic management of various vehicle signals.

However, an existing vehicle-mounted black box has weak impact resistance and high-temperature resistance during use, which further make internal storage data easily destroyed, resulting in data loss, and thus has a problem of potential safety hazards in use.

WO2018093773 A1 discloses multiply-insulated articles, comprising at least first and second containers disposed together, US2014022722 A1 discloses systems and methods for protecting a flight recorder, WO2019084485 A1 teaches various systems for thermal protection, and US5123538A discloses a crash protection enclosure for solid state memory devices.

### SUMMARY

In order to overcome the defects of the prior art, the invention provides a protector for vehicle-mounted black box, which solves the technical problem that the existing vehicle-mounted black box has weak impact resistance and high-temperature resistance during use, which further make internal storage data easily destroyed, resulting in data loss, and thus has potential safety hazards in use.

In order to achieve the above-described objective, technical solutions adopted by the present invention are according to the independent claim, while additional aspects of the invention are reflected in the dependent claims.

As compared with the closest prior art, the technical solutions of the present disclosure have advantageous effects below:

The protector for vehicle-mounted black box provided by the present disclosure, has the damping material filled in the gap between the data storage module and the inner shell body, which, as compared with the existing protector for vehicle-mounted black box, has impact resistance greatly improved, further makes the internal storage data not easily destroyed, reduces a data loss rate, and thus improves safety in use of the vehicle-mounted black box.

The protector for vehicle-mounted black box provided by the present disclosure has the heat insulating material filled in the gap between the inner shell body and the outer shell body, which, as compared with the existing protector for vehicle-mounted black box, has high-temperature resistance greatly improved, further makes the internal storage data not easily destroyed, reduces a data loss rate, and thus improves safety in use of the vehicle-mounted black box.

### BRIEF DESCRIPTION OF THE DRAWINGS

In order to clearly illustrate the technical solution of the embodiments of the present disclosure or in the prior art, the drawings that need to be used in description of the embodiments or the prior art will be briefly described in the following; it is obvious that the described drawings are only related to some embodiments of the present disclosure; based on the drawings, those ordinarily skilled in the art can acquire other drawings, without any inventive work.
FIG 1 is a structural exploded view of a protector for vehicle-mounted black box according to the present disclosure;
FIG 2 is an internal cross-sectional view of the protector for vehicle-mounted black box of FIG 1;
FIG 3 is a stereoscopic schematic diagram of an outer shell body according to the present disclosure;
FIG 4 is a stereoscopic schematic diagram of an outer cover body of the present disclosure;
FIG 5 is a stereoscopic schematic diagram of an inner shell body according to the present disclosure;
FIG 6 is a stereoscopic schematic diagram of an inner cover body according to the present disclosure;
FIG 7 is a structural schematic diagram of a rubber sleeve according to the present disclosure; and
FIG 8 is a structural schematic diagram of a protective cylinder according to the present disclosure;

In which, 1-inner shell body, 2-inner cover body, 3-data storage module, 4-cable, 5-via hole, 6-rectangular protrusion, 7-damping material, 8-outer shell body, 9-outer cover body, 10-counterbore, 11-screw, 12-plug, 13-heat insulating material, 14-rubber sleeve, 15-protective cylinder, 16-annular protrusion.

### DETAILED DESCRIPTION

Hereinafter, the technical solutions of the present disclosure will be described in a clearly and fully understandable way in connection with the embodiments of the present disclosure. It is obvious that the described embodiments are just a part but not all of the embodiments of the present disclosure. Based on the described embodiments herein, those ordinarily skilled in the art can obtain other embodiment(s), without any inventive work, which should be within the scope of the present disclosure.

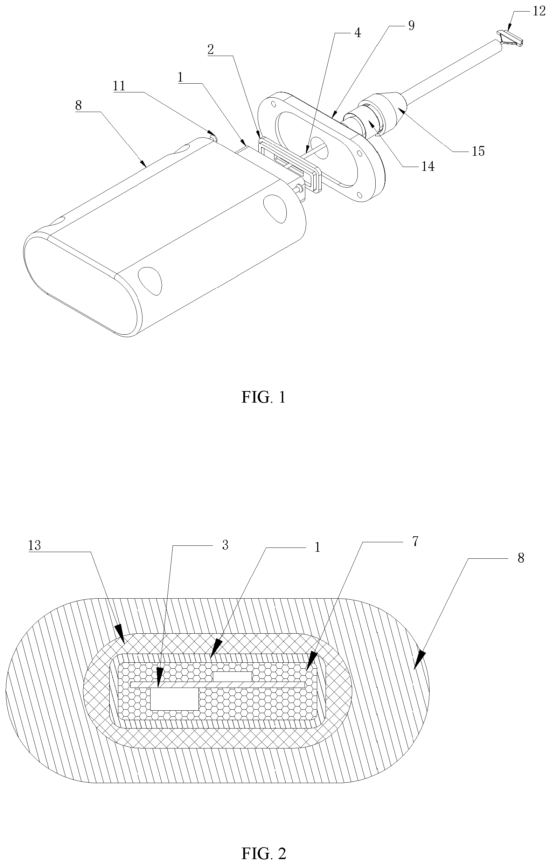

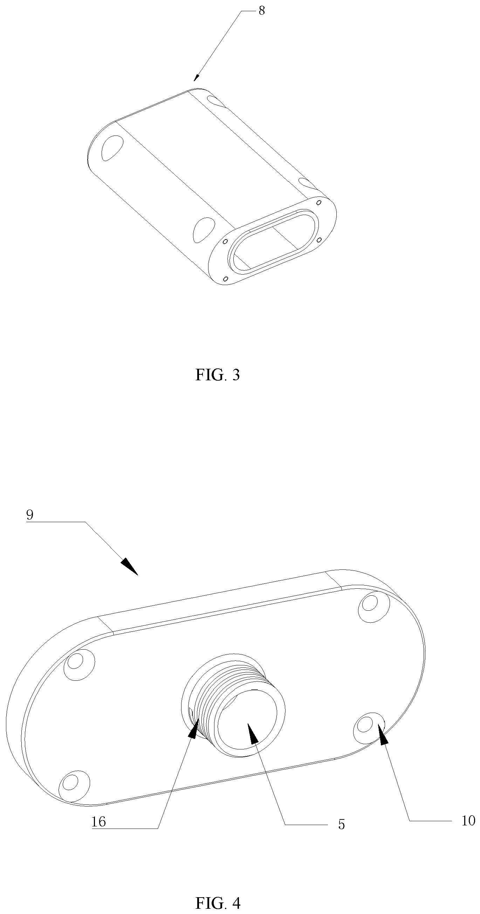

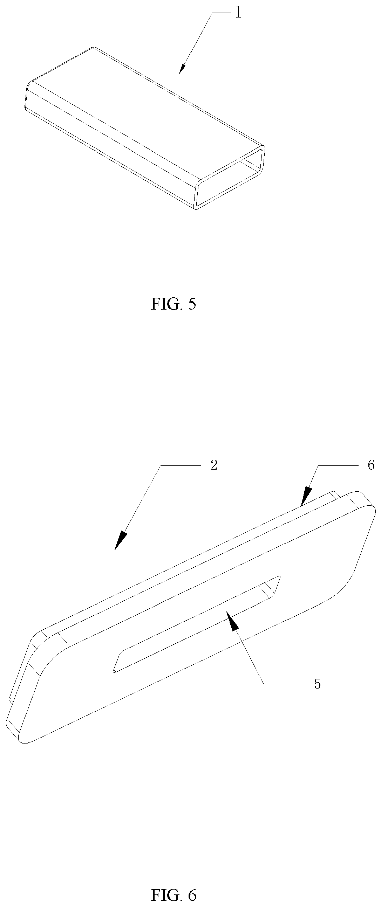

Referring to FIG 1 to FIG 6, a protector for vehicle-mounted black box according to the present disclosure comprises an inner shell body 1, an inner cover body 2, a data storage module 3 and a cable 4; wherein, the inner cover body 2 is opened thereon with a via hole 5; the inner shell body 1 and the inner cover body 2 are preferably made of a stainless steel material; the data storage module 3 and the cable 4 are not specifically limited in structure, for which the prior art may be just adopted; the data storage module 3 preferably adopts an existing Printed Circuit Board (PCB) storage structure;

An opening end of the inner shell body 1 is firmly connected to the inner cover body 2; in order to facilitate disassembly and replacement between the inner shell body 1 and the inner cover body 2, the opening end of the inner shell body 1 and the inner cover body 2 are detachably connected, and a specific connection relationship is that: the inner cover body 2 has an internally hollow rectangular protrusion 6 integrally formed in a direction perpendicular to itself around the via hole 5 within a cover surface on a side to be connected with the inner shell body 1, and an outer wall of the rectangular protrusion 6 is clamped with an inner wall of the opening end of the inner shell body 1;

In order to further improve connection tightness between the inner cover body 2 and the inner shell body 1, damping potting glue is filled between the outer wall of the rectangular protrusion 6 and the inner wall of the opening end of the inner shell body 1;

The data storage module 3 is placed in the inner shell body 1; and the cable 4 has one end connected with the data storage module 3, and the other end run through the via hole 5 of the inner cover body 2 for data transmission with the external;

In order to improve impact resistance of the protector for vehicle-mounted black box, the vehicle-mounted black box according to the present disclosure further comprises a damping material 7; the damping material 7 is filled in a gap between the data storage module 3 and the inner shell body 1; and the damping material 7 is preferably polyurethane potting glue;

The above-described damping material filled in the gap between the data storage module and the inner shell body, as compared with the existing protector for vehicle-mounted black box, has impact resistance greatly improved, further makes the internal storage data not easily destroyed, reduces a data loss rate, and thus improves safety in use of the vehicle-mounted black box.

In order to improve strength of the protector for vehicle-mounted black box, the protector for vehicle-mounted black box further comprises an outer shell body 8 and an outer cover body 9; a via hole 5 is opened in the middle of the outer cover body 9; and the outer shell body 8 and the outer cover body 9 are preferably made of a stainless steel material;

An opening end of the outer shell body 8 is firmly connected to the outer cover body 9; in order to facilitate disassembly and replacement between the outer shell body 8 and the outer cover body 9, the outer shell body 8 and the outer cover body 9 are preferably detachably connected, and a specific connection relationship is that: the outer cover body 9 has via holes 5 opened on cover body edges thereof; the outer shell body 8 has counterbores 10 opened on a wall surface of the opening end in positions corresponding to the via holes on the cover body edges of the outer cover body 9; the two are connected by screws 11; and it can be seen from the diagram that the numbers of via holes and counterbores are 4 each;

The inner shell body 1 is placed in the outer shell body 8; and the end of the cable 4 that runs through the inner cover body 2 extends out of the via hole 5 located in the middle of the outer cover body 9 for data transmission with the external.

In order to further improve impact resistance of the protector for vehicle-mounted black box, corners of the outer shell body 8 are set to be curved; radians are specifically set by a machining process; and an arc radius R=15 mm to 25 mm, preferably 18.5 mm.

In order to facilitate external data transmission to the internal data storage module 3 through the cable 4, the protector for vehicle-mounted black box further comprises a plug 12; and the plug 12 is firmly connected to an end of a portion of the cable 4 that extends out of the outer cover body 9.

In order to improve heat resistance of the vehicle-mounted black box, the protector for vehicle-mounted black box further comprises a heat insulating material 13; the heat insulating material 13 is filled in a gap between the inner shell body 1 and the outer shell body 8; and the heat insulating material 13 is preferably an inorganic silicon insulating tile.

In order to further improve heat resistance of the vehicle-mounted black box, the protector for vehicle-mounted black box further comprises a heat insulating layer (not shown); and the heat insulating layer may be sprayed specifically in three modes below:
(1) The heat insulating layer is sprayed on an outer wall of the outer shell body 8;
(2) The heat insulating layer is sprayed on an outer wall of the inner shell body 1; and
(3) The heat insulating layer is sprayed on the outer wall of the outer shell body 8 and the outer wall of the inner shell body 1;

A spraying thickness of the above-described heat insulating layer is controlled within 1 mm; and the heat insulating layer is preferably made of an existing high-temperature reflective heat-insulating nano-composite ceramic coating material.

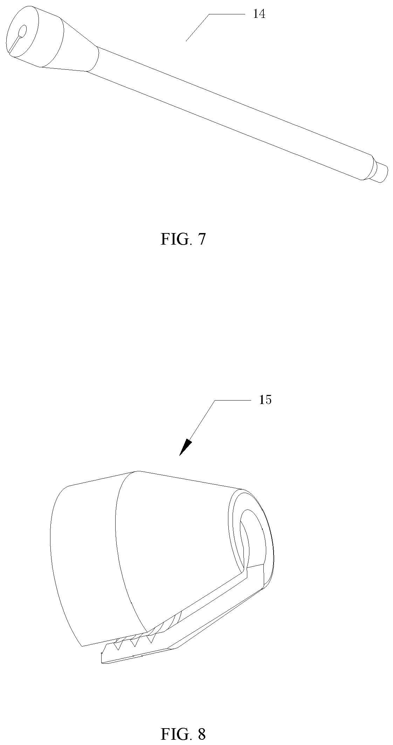

Because the cable for data transmission is relatively thin, in order to take certain protective measures for the portion of the cable that extends out of the outer cover body, the protector for vehicle-mounted black box further comprises a protective layer; the protective layer is sleeved on an outer wall surface of the portion of the cable that extends out of the outer cover body; and the protective layer is specifically a rubber sleeve 14 (as shown in FIG 7);

In order to facilitate the rubber sleeve 14 to be sleeved on the outer wall surface of the cable 4, a notch is opened along a length direction of the rubber sleeve 14, so as to facilitate the rubber sleeve 14 to be sleeved on the outer wall surface of the cable 4;

During a process that the rubber sleeve 14 opened with the notch is sleeved on the outer wall surface of the cable 4, if a tube hole diameter of the rubber sleeve 14 is relatively small, a portion of the cable 4 may be exposed to the air, or the rubber sleeve 14 cannot be sleeved on the cable 4, so that the cable 4 cannot be protected; in order to solve the problem, a heat shrinkable sleeve (not shown) is sleeved on an outer wall of the rubber sleeve 14; when heated, the heat shrinkable sleeve will be tightly sleeved on the outer wall of the rubber sleeve 14, assisting the rubber sleeve 14 to protect the cable 4; the heat shrinkable sleeve is not specifically limited in structure, and an existing commercially available heat shrinkable sleeve may just be adopted.

In order to further improve protection performance for the cable and prevent the cable portion outside the outer cover body 9 from bending, as shown in FIG 8, the protector for vehicle-mounted black box further comprises a protective cylinder 15; the protective cylinder is made of a stainless steel material; the protective cylinder 15 is sleeved on an end of the outer wall of the protective layer that is close to the outer cover body, and is firmly connected to the outer cover body 9, and a specific connection relationship is that: an inner wall of the protective cylinder 15 has an internal thread opened at an end connected with the outer cover body 9, and the outer cover body 9 has an annular protrusion 16 integrally formed in a direction perpendicular to the outer cover body 9 around the via hole 5 in the middle portion on a surface to be connected with the protective cylinder 15, an outer wall of the annular protrusion 16 is opened with an external thread, and the external thread is connected with the internal thread;

As described above, the protective cylinder is sleeved on one end of the outer wall of the protective layer that is close to the outer cover body, which may increase a bending radius of the cable, so as to prevent the cable from bending.

## Claims

1. A protector for a vehicle-mounted black box, the protector comprising an inner shell body (1), an inner cover body (2), a data storage module (3) and a cable (4); wherein, the data storage module (3) is placed in the inner shell body (1); an opening end of the inner shell body (1) is firmly connected to the inner cover body (2); the cable (4) has one end connected with the data storage module (3), and the other end runs through the inner cover body (2) for external data transmission; the protector also comprising a damping material (7), the damping material (7) being filled in a gap between the data storage module (3) and the inner shell body (1);
the protector also comprising an outer shell body (8) and an outer cover body (9); wherein, an opening end of the outer shell body (8) is firmly connected to the outer cover body (9); the inner shell body (1) is placed in the outer shell body (8); and the end of the cable (9) that runs through the inner cover body (2) extends out of the outer cover body (9) for external data transmission;
**characterized in that** the protector also comprises a protective layer, the protective layer being sleeved on an outer wall surface of a portion of the cable (9) that extends out of the outer cover body (9),
the protective layer is specifically a rubber sleeve (14), wherein a notch is opened along a length direction of the rubber sleeve (14), so as to facilitate the rubber sleeve (14) to be sleeved on the outer wall surface of the cable (4);
further comprising a protective cylinder (15) for protecting the cable (4) outside the outer cover body (9); wherein, the protective cylinder is sleeved on an end of an outer wall of the protective layer that is close to the outer cover body (9), and is firmly connected to the outer cover body (9);
wherein an inner wall of the protective cylinder (15) has an internal thread opened at an end connected with the outer cover body (9), and the outer cover body (9) has an annular protrusion (16) integrally formed, in a direction perpendicular to the outer cover body (9), around a hole (5) in a middle portion on a surface to be connected with the protective cylinder (15), an outer wall of the annular protrusion (16) is equipped with an external thread, and the external thread of annular protrusion (16) is connected with the internal thread of the protective cylinder (15).

2. The protector for the vehicle-mounted black box according to claim 1, comprising a heat insulating material (13); the heat insulating material being filled in a gap between the inner shell body (1) and the outer shell body (8).

3. The protector for the vehicle-mounted black box according to claim 1, comprising a heat insulating layer; the heat insulating layer being sprayed on an outer wall of the outer shell body (8).

4. The protector for the vehicle-mounted black box according to any one of claims 1 to 3, comprising a heat insulating layer; the heat insulating layer being sprayed on an outer wall of the inner shell body (1).

5. The protector for the vehicle-mounted black box according to claim 1, comprising a plug (12); the plug (12) being firmly connected to an end of the portion of the cable (9) that extends out of the outer cover body (9).

6. The protector for the vehicle-mounted black box according to claim 1, wherein corners of the outer shell body (8) are set to be curved.

## Patentansprüche

1. Schutz für einen fahrzeugmontierten Fahrdatenschreiber, wobei der Schutz einen inneren Schalenkörper (1), einen inneren Abdeckkörper (2), ein Datenspeichermodul (3) und ein Kabel (4) umfasst; wobei das Datenspeichermodul (3) in dem inneren Schalenkörper (1) platziert ist; ein Öffnungsende des inneren Schalenkörpers (1) fest mit dem inneren Abdeckkörper (2) verbunden ist; das Kabel (4) ein Ende aufweist, das mit dem Datenspeichermodul (3) verbunden ist, und das andere Ende zur externen Datenübertragung durch den inneren Abdeckkörper (2) verläuft; wobei der Schutz auch ein Dämpfungsmaterial (7) umfasst, wobei das Dämpfungsmaterial (7) in einen Spalt zwischen dem Datenspeichermodul (3) und dem inneren Schalenkörper (1) eingefüllt ist;
wobei der Schutz auch einen äußeren Schalenkörper (8) und einen äußeren Abdeckkörper (9) umfasst; wobei ein Öffnungsende des äußeren Schalenkörpers (8) fest mit dem äußeren Abdeckkörper (9) verbunden ist; der innere Schalenkörper (1) in dem äußeren Schalenkörper (8) platziert ist; und sich das Ende des Kabels (9), das durch den inneren Abdeckkörper (2) verläuft, zur externen Datenübertragung aus dem äußeren Abdeckkörper (9) heraus erstreckt;
**dadurch gekennzeichnet, dass** der Schutz auch eine Schutzschicht umfasst, wobei die Schutzschicht auf einer Außenwandoberfläche eines Abschnitts des Kabels (9), der sich aus dem äußeren Abdeckkörper (9) heraus erstreckt, aufgeschoben ist,
die Schutzschicht insbesondere eine Gummihülse (14) ist, wobei eine Einkerbung entlang einer Längsrichtung der Gummihülse (14) geöffnet ist, um ein Aufschieben der Gummihülse (14) auf die Außenwandoberfläche des Kabels (4) zu erleichtern;
ferner umfassend einen Schutzzylinder (15) zum Schützen des Kabels (4) außerhalb des äußeren Abdeckkörpers (9); wobei der Schutzzylinder auf einem Ende einer Außenwand der Schutzschicht aufgeschoben ist, das sich in der Nähe des äußeren Abdeckkörpers (9) befindet, und fest mit dem äußeren Abdeckkörper (9) verbunden ist;
wobei eine Innenwand des Schutzzylinders (15) ein Innengewinde aufweist, das an einem mit dem äußeren Abdeckkörper (9) verbundenen Ende geöffnet ist, und der äußere Abdeckkörper (9) einen ringförmigen Vorsprung (16) aufweist, der in einer Richtung senkrecht zu dem äußeren Abdeckkörper (9) um ein Loch (5) in einem mittleren Abschnitt auf einer Oberfläche, die mit dem Schutzzylinder (15) zu verbinden ist, einstückig ausgebildet ist, wobei eine Außenwand des ringförmigen Vorsprungs (16) mit einem Außengewinde versehen ist und das Außengewinde des ringförmigen Vorsprungs (16) mit dem Innengewinde des Schutzzylinders (15) verbunden ist.

2. Schutz für den fahrzeugmontierten Fahrdatenschreiber nach Anspruch 1, umfassend ein wärmeisolierendes Material (13); wobei das wärmeisolierende Material in einen Spalt zwischen dem inneren Schalenkörper (1) und dem äußeren Schalenkörper (8) eingefüllt ist.

3. Schutz für den fahrzeugmontierten Fahrdatenschreiber nach Anspruch 1, umfassend eine wärmeisolierende Schicht; wobei die wärmeisolierende Schicht auf eine Außenwand des äußeren Schalenkörpers (8) gespritzt ist.

4. Schutz für den fahrzeugmontierten Fahrdatenschreiber nach einem der Ansprüche 1 bis 3, umfassend eine wärmeisolierende Schicht; wobei die wärmeisolierende Schicht auf eine Außenwand des inneren Schalenkörpers (1) gespritzt ist.

5. Schutz für den fahrzeugmontierten Fahrdatenschreiber nach Anspruch 1, umfassend einen Stecker (12); wobei der Stecker (12) fest mit einem Ende des Abschnitts des Kabels (9) verbunden ist, der sich aus dem äußeren Abdeckkörper (9) heraus erstreckt.

6. Schutz für den fahrzeugmontierten Fahrdatenschreiber nach Anspruch 1, wobei Ecken des äußeren Schalenkörpers (8) gerundet sein sollen.

## Revendications

1. Dispositif de protection pour une boîte noire montée sur un véhicule, le dispositif de protection comprenant un corps de coque interne (1), un corps de couvercle interne (2), un module de stockage de données (3) et un câble (4) ; ledit module de stockage de données (3) étant placé dans le corps de coque interne (1) ; une extrémité d'ouverture du corps de coque interne (1) étant fermement raccordée au corps de couvercle interne (2) ; ledit câble (4) possédant une extrémité raccordée au module de stockage de données (3), et l'autre extrémité traversant le corps de couvercle interne (2) pour la transmission de données externes,
le dispositif de protection comprenant également un matériau d'amortissement (7), le matériau d'amortissement (7) étant rempli dans un espace entre le module de stockage de données (3) et le corps de coque interne (1) ;
le dispositif de protection comprenant également un corps de coque externe (8) et un corps de couvercle externe (9) ; une extrémité d'ouverture du corps de coque externe (8) étant fermement raccordée au corps de couvercle externe (9) ; ledit corps de coque interne (1) étant placé dans le corps de coque externe (8) ; et ladite extrémité du câble (9) qui traverse le corps de couvercle interne (2) s'étendant hors du corps de couvercle externe (9) pour une transmission de données externe ;
**caractérisé en ce que** le dispositif de protection comprend également une couche de protection, la couche de protection étant gainée sur une surface de paroi externe d'une partie du câble (9) qui s'étend hors du corps de couvercle externe (9),
la couche de protection est spécifiquement un manchon en caoutchouc (14), une encoche étant ouverte le long d'une direction de longueur du manchon en caoutchouc (14), de façon à faciliter le gainage de la surface de paroi externe du câble (4) avec le manchon en caoutchouc (14) ;
comprenant en outre un cylindre de protection (15) destiné à protéger le câble (4) à l'extérieur du corps de couvercle externe (9) ; ledit cylindre de protection étant gainé sur une extrémité d'une paroi externe de la couche de protection qui est proche du corps de couvercle externe (9), et étant fermement raccordé au corps de couvercle externe (9) ;
une paroi interne du cylindre de protection (15) possédant un filetage intérieur ouvert au niveau d'une extrémité raccordée au corps de couvercle externe (9), et le corps de couvercle externe (9) possédant une saillie annulaire (16) formée d'un seul tenant, dans une direction perpendiculaire au corps de couvercle externe (9), autour d'un trou (5) dans une partie médiane sur une surface à raccorder au cylindre de protection (15), une paroi externe de la saillie annulaire (16) étant
équipée d'un filetage extérieur, et ledit filetage extérieur de la saillie annulaire (16) étant raccordée au filetage intérieur du cylindre de protection (15).

2. Dispositif de protection pour la boîte noire montée sur un véhicule selon la revendication 1, comprenant un matériau d'isolation thermique (13) ; le matériau d'isolation thermique remplissant un espace entre le corps de coque interne (1) et le corps de coque externe (8).

3. Dispositif de protection pour la boîte noire montée sur un véhicule selon la revendication 1, comprenant une couche d'isolation thermique ; la couche d'isolation thermique étant pulvérisée sur une paroi externe du corps de coque externe (8).

4. Dispositif de protection pour la boîte noire montée sur un véhicule selon l'une quelconque des revendications 1 à 3,
comprenant une couche d'isolation thermique ; la couche d'isolation thermique étant pulvérisée sur une paroi externe du corps de coque interne (1).

5. Dispositif de protection pour la boîte noire montée sur un véhicule selon la revendication 1, comprenant une fiche (12) ; la fiche (12) étant fermement raccordée à une extrémité de la partie du câble (9) qui s'étend hors du corps de couvercle externe (9).

6. Dispositif de protection pour la boîte noire montée sur un véhicule selon la revendication 1, lesdits coins du corps de coque externe (8) étant définis pour être incurvés.
